Europäisches Patentamt

European Patent Office

Office européen des brevets

(11) Veröffentlichungsnummer: **0 453 651 A1**

## (12) EUROPÄISCHE PATENTANMELDUNG

(21) Anmeldenummer: 90124635.5

(22) Anmeldetag: 18.12.90

(51) Int. Cl.5: **H03K 19/0185**, H03K 19/018

(30) Priorität: 23.04.90 DE 4012914

(43) Veröffentlichungstag der Anmeldung:
**30.10.91 Patentblatt 91/44**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) **Schaltstufe.**

(57) Eine CMOS-Schaltstufe (STV) mit einem ersten und einem zweiten Stromversorgungspfad zum Anschluß an jeweils ein Versorgungsspannungspotential weist wenigstens in einem der Stromversorgungspfade ein Spannungsverringerungsglied (SB) auf. Über diesem Spannungsverringerungsglied (SB) stellt sich eine weitgehend stromstärkenunabhängige Spannungsdifferenz ein. Die Transistoren dieser CMOS-Schaltstufe (STV) können in integrierten Schaltungen kleiner ausgebildet werden, da die Drain-Source-Spannung der Transistoren verringert ist. In Schaltungen mit Stromschalter-Schaltstufen bietet die erfindungsgemäß ausgebildete CMOS-Schaltstufe (STV) besondere Vorteile, weil sich aufgrund des verringerten Ausgangssignalpegelhubs und der entsprechend angepaßten Schaltschwelle bei der CMOS-Schaltstufe (STV) der Aufwand für Signalpegelwandler zur Umsetzung von Stromschalter-Ausgangssignalpegeln auf CMOS-Eingangssignalpegel wesentlich verringert.

FIG 2

EP 0 453 651 A1

Die Erfindung betrifft eine Schaltstufe gemäß dem Oberbegriff des Patentanspruchs 1.

Eine derartige Schaltstufe ist aus der DE-OS 33 00 869 bekannt. Zwei komplementären MOS-Schalttransistoren ist jeweils ein als Lastwiderstand geschalteter komplementärer MOS-Transistor zugeordnet und gegen jeweils das zugeordnete Versorgungspotential geschaltet. Die Schaltstufe wirkt als Potentialteiler, bei der die Lastwiderstände einen stromabhängigen Spannungsabfall bewirken. Eine Kompensation von Prozeß- und Temperatur- bzw. Versorgungsspannungsschwankungen ist nicht möglich, was sich bei pegelempfindlichen Schaltungen nachteilig auf die Funktionssicherheit auswirkt.

Mit Entwicklung des sogenannten "BiCMOS"-Prozesses bei der Herstellung von integrierten Schaltungen wurden die Grundlagen dafür geschaffen, um auch digitale Schaltungsanordnungen, die aus einer Kombination von Schaltstufen in Bipolartechnologie und komplementär MOS-Technologie bestehen als integrierte Schaltung auszubilden.

Von besonderem Interesse ist die Kombination der schnellen und verlustleistungsintensiven Logikschaltstufen in Stromschalter-Schaltkreistechnik, die in ihren Ausführungsformen auch als ECL (Emitter Coupled Logic)- und CML (Current Mode Logic)-Schaltstufen bekannt sind, mit den weniger schnellen dafür aber extrem verlustleistungsarmen Schaltstufen der komplementären MOS- (CMOS)-Schaltkreistechnik.

So können z. B. in Digitalschaltungen die aus Geschwindigkeitsgründen wengistens zum Teil mit CML-Schaltstufen realisiert sein müssen, alle diejenigen Schaltungsteile mit CMOS-Schaltstufen ausgeführt werden, die geringeren Geschwindigkeitsanforderungen unterliegen. Die Verlustleistung einer solchen integrierten Schaltung ist gegenüber einer ausschließlich mit CML-Schaltstufen versehenen integrierten Schaltung erheblich geringer.

Diesem Vorteil steht jedoch die Tatsache entgegen, daß die Stromschalter und CMOS-Schaltkreistechnik verschiedene Spannungswerte für ihre digitalen Signalpegel vorsehen und deshalb ein Signalfluß zwischen Schaltstufen unterschiedlicher Schaltkreistechnik nur über sogenannte Signalpegelwandler vollziehbar ist.

Da als gemeinsame Energieversorgung für die Schaltstufen beider Schaltkreistechniken ein Bezugspotential in Höhe von 0 V, und ein Versorgungsspannungpotential in Höhe von ca. -5 V verwendet wird, muß ein Signalpegelwandler z. B. zur Umsetzung von CML-Ausgangssignalpegeln, die bei 0 V und ca. -0,5 V liegen, in CMOS-Eingangssignalpegel, die den Spannungswerten des Bezugspotentials und des Versorgungsspannungspotentials entsprechen, einen Signalpegelhub von 0,5 V um den Faktor 10 erhöhen.

Eine Verwendung von solchen Signalpegelwandlern hat sich als problematisch erwiesen, da der hohe Verstärkungsfaktor sehr schwierig und nur mit hohem Aufwand zu erreichen ist, und die Signalpegelwandler aufgrund dieses hohen Verstärkungsfaktors sehr störanfällig sind.

Die Aufgabe der vorliegenden Erfindung ist es daher, in einer Digitalschaltung der eingangs beschriebenen Art schaltungstechnische Maßnahmen anzugeben, mit denen sich der Aufwand für die Signalpegelwandler verringern und ihre Funktionssicherheit erhöhen läßt.

Gelöst wird die Aufgabe erfindungsgemäß durch die kennzeichnenden Merkmale des Patentanspruchs 1.

Mit der Erfindung wird der wesentliche Vorteil erzielt, daß zur Umsetzung von CML-Ausgangssignalpegeln auf CMOS-Eingangssignalpegel mit verringertem Pegelhub ein geringer Verstärkungsfaktor (z. B. ein Verstärkungsfaktor 4) erforderlich ist, der ohne Probleme und Aufwand mit einem störunanfälligen Signalpegelwandler realisierbar ist.

Im Hinblick auf die Signaldurchlaufzeit der Signalpegelwandler ergibt sich ein weiterer Vorteil, da sich die Signaldurchlaufzeit direkt proportional zum Verstärkungsfaktor verhält und deshalb mit der integrierten Schaltung höhere Verarbeitungsgeschwindigkeit erzielbar sind.

Ein besonderer Vorteil besteht zudem darin, daß zur Umsetzung von CMOS-Ausgangssignalpegeln mit verringertem Signalpegelhub auf CML-Eingangssignalpegel in den meisten Fällen kein Signalpegelwandler erforderlich ist.

Eine Anpassung der Ausgangssignalpegel von CMOS-Schaltstufen mit verringertem Signalpegelhub auf CMOS-Schaltstufen mit vollem Signalpegelhub, die z. B. außerhalb der integrierten Schaltung angeordnet sind, ist mit einem entsprechenden Signalpegelwandler problemlos zu realisieren, wobei in vielen Fällen auf einen Signalpegelwandler zur Umsetzung des vollen Signalpegelhubes auf den verringerten Signalpegelhub verzichtet werden kann.

Vorteilhafte Weiterbildungen der Erfindung sind in Unteransprüchen 3 bis 7 angegeben.

Ein besonderer Vorteil mit erfindungsgemäß ausgebildeten CMOS-Schaltstufen ergibt sich, wie im Patentanspruch 2 angegeben, für integrierte Schaltungen im Subminiaturbereich. Die zunehmende Miniaturisierung bei integrierten Schaltungen bringt nämlich hinsichtlich der Spannungsverträglichkeit von Transistor- und Leiterstrukturen erhebliche Probleme mit sich. Selbst bei der relativ geringen Standardversorgungsspannung von 5 V dürfen die Transistorstrukturen innerhalb der integrierten Schaltung einen bestimmten Miniaturisierungsgrad nicht unterschreiten, um Ladungsausgleiche aufgrund des Durchschlageffektes auszuschließen.

Da zwischen den Drain- und Source-Elektroden der zur Bildung von CMOS-Schaltstufen vorgesehenen Feldeffekttransistoren die Versorgungsspannung in voller Höhe anliegt, müssen diese Feldeffekttransistoren bisher für eine Drain-Source-Spannung von wenigstens 5 V ausgelegt sein, um eine Kompatibilität zu gewährleisten.

Die CMOS-Schaltstufe gemäß der Erfindung läßt sich mit kleineren Transistorstrukturen realisieren, weil durch das Spannungsverringerungsglied die an den Feldeffekttransistoren auftretende Drain-Source-Spannung gegenüber der Versorgungsspannung verringert wird.

Mit einer Konstantspannungsquelle als Spannungsverringerungsglied, wie im Patentanspruch 6 angegeben, bleiben die CMOS-Schaltstufen in ihren beiden Zuständen vorteilhafterweise stromlos.

Im folgenden werden Ausführungsbeispiele der Erfindung anhand der Zeichnung näher erläutert. Dabei zeigen:

FIG 1    eine schematische Darstellung der auf einer integrierten Schaltung befindlichen Schaltstufen in Stromschalter (CML) - und CMOS-Schaltkreistechnik,

FIG 2    ein Schaltbild für eine auf der integrierten Schaltung nach Figur 1 angeordnete und mit verringertem Signalpegelhub versehene CMOS-Schaltstufe,

FIG 3    ein Schaltbild für einen in BiCMOS-Technologie ausgebildeten Signalpegelwandler zur Umsetzung von Ausgangssignalpegeln von Schaltstufen in Stromschaltertechnik (CML) auf Eingangssignalpegel von CMOS-Schaltstufen verringertem Signalpegelhub,

FIG 4    ein Schaltbild für einen auf der Grundlage einer Schaltstufe in Stromschalter-Schaltkreistechnik ausgebildeten Signalpegelwandlers als Alternative zu einem nach Figur 3 ausgebildeten Signalpegelwandler.

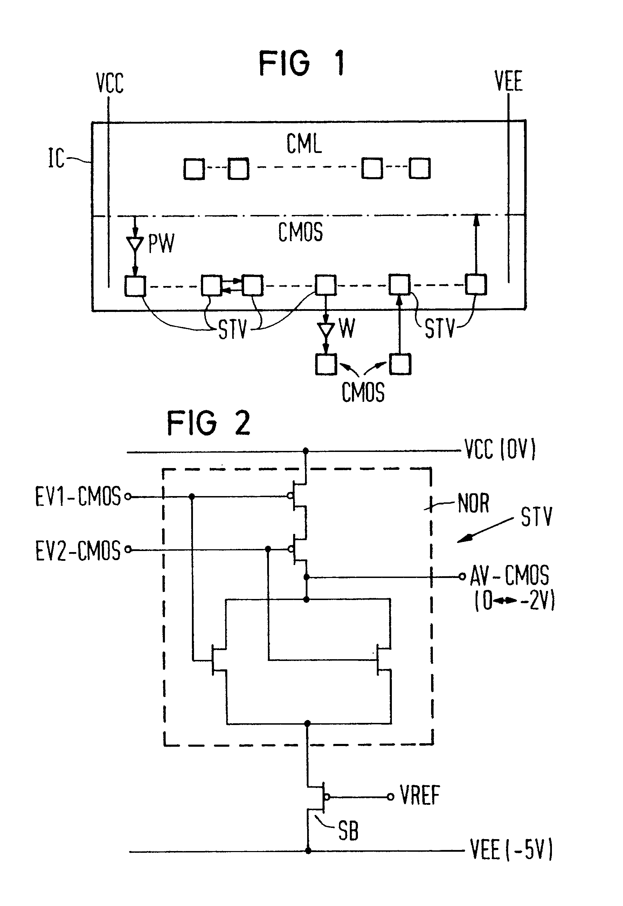

In der Figur 1 ist schematisch stark vereinfacht eine integrierte Schaltung IC dargestellt, deren Schaltungsfläche mit einer Unterteilung in einem oberen und einen unteren Bereich versehen ist. Der obere Bereich soll stellvertretend für alle Schaltungsteile stehen, die ausschließlich mit Schaltstufen in Stromschaltertechnik z.B. in CML (Current Mode Logic)-Schaltkreistechnik realisiert sind. Der untere Bereich dagegen, soll die mit Schaltstufen der CMOS-Schaltkreistechnik erstellten Schaltungsteile repräsentieren.

Die in CML-Technik realisierten Schaltstufen werden im folgenden als erste und die in CMOS-Technik realisierten Schaltstufen als zweite Schaltstufen bezeichnet. Zur Vereinfachung wird außerdem angenommen, daß sämtliche zweite Schaltstufen auf der integrierten Schaltung IC mit einer Schaltungsanordnung (nicht dargestellt) zur Verringerung ihres Ausgangssignalpegelhubes und zur Anpassung ihrer Schaltschwelle versehen sind.

Zur Energieversorgung sämtlicher Schaltungsteile der integrierten Schaltung IC ist ein Bezugspotential VCC (0 V) und ein Versorgungsspannungspotential VEE (z. B. -5 V) vorhanden.

Abgesehen von den Schaltstufenverbindungen (nicht dargestellt) im oberen Bereich, sind Signalpfade vorgesehen, die jeweils ausgehend von irgendeiner CML-Schaltstufe über einen Signalpegelwandler PW zu einer oder mehreren zweiten Schaltstufen STV im unteren Bereich führen.

Diese Signalpegelwandler PW setzen den in der CML-Schaltkreistechnik zur Repräsentation eines digitalen "L"-Wertes vorgesehenen Spannungswert von ca. -0,5 V in einen Spannungswert von z.B. ca. -2 V um. Der zur Repräsentation eines digitalen "H"-Wertes vorgesehene Spannungswert entspricht dem des Bezugspotentials VCC und bleibt durch einen Signalpegelwandler PW unverändert.

Für die digitalen Pegel auf den Signalpfaden zwischen den zweiten Schaltstufen im unteren Bereich sind die gleichen Spannungswerte nämlich 0 V für einen digitalen H-Pegel und -2 V für einen digitalen L-Pegel vorgesehen.

Auf einen Signalpegelwandler in einen Signalpfad von einer zweiten Schaltstufe STV zu einer oder mehreren ersten Schaltstufen kann bei einem Spannungswert von ca. -2 V für einen digitalen L-Pegel in der Regel verzichtet werden.

Für den Fall, daß Signalpfade ausgehend von den zweiten Schaltstufen STV zu außerhalb der integrierten Schaltung IC befindlichen und in CMOS-Schaltkreistechnik ausgebildeten zweiten Schaltstufen vorhanden sind, müssen diese Signalpfade jeweils über einen weiteren Signalpegelwandler W geführt werden, der den auf 2 V verringerten Signalpegelhub auf einen bei herkömmlichen CMOS-Schaltungen üblichen vollen Signalpegelhub z.B. 5 V umsetzt. Solche weiteren Signalpegelwandler W können außerhalb oder innerhalb der integrierten Schaltung IC angeordnet sein, wobei im Falle einer letzteren Anordnung die integrierte Schaltung IC im Hinblick auf CMOS-Signalpegel kompatibel zur herkömmlichen CMOS-Schaltstufen ist.

In Signalpfaden ausgehend von CMOS-Schaltstufen außerhalb der integrierten Schaltung IC hin zu zweiten Schaltstufen mit verringertem Signalpegelhub auf der integrierten Schaltung IC sind in der Regel keine Signalpegelwandler erforderlich.

In der Figur 2 ist ein Stromlaufplan für eine auf der integrierten Schaltung angeordnete zweite Schaltstufe dargestellt, die eine Schaltungsanordnung zur Verringerung des Ausgangssignalpegelhubes und Anpassung der Schaltschwelle aufweist.

Diese zweite Schaltstufe STV besteht im wesentlichen aus einer in herkömmlicher CMOS-Logik ausgebildeten Nicht-Oder-Stufe NOR mit zwei Signaleingängen EV1-CMOS, EV2-CMOS und einem Signalausgang AV-CMOS. Die zur Bildung dieser bekannten Nicht-Oder-Stufe NOR erforderlichen Schalttransistoren sowie deren Verbindung sind in der Figur aus Übersichtlichkeitsgründen von einem rechteckigen Rahmen mit unterbrochener Kantenlinie umgeben.

An das Bezugspotential VCC (0 V) ist die Nicht-Oder-Stufe NOR in herkömmlicher Weise angeschlossen. Mit dem Versorgungsspannungspotential VEE dagegen ist die Nicht-Oder-Stufe NOR über die Source-Drain-Strecke eines zur Bildung einer Konstantspannungsquelle dienenden Feldeffekttransistors SB verbunden. Dieser Feldeffekttransistor SB ist als selbstsperrender P-Kanal-MOS-FET ausgebildet, wobei das in der Zeichnung gewählte Symbol einen symmetrischen Feldeffekttransistor zugrundelegt. Die Gateelektrode dieses Feldeffekttransistors SB ist mit einem Referenzspannungspotential VREF zur Einstellung der von der Konstantspannungsquelle abzugebenden Konstantspannung beaufschlagt.

Mit der von dem Feldeffekttransistor SB gebildeten Konstantspannungsquelle wird der Nicht-Oder-Stufe NOR eine Versorgungsspannung zugeführt, deren Spannungswert (-2 V) um den Betrag der Konstantspannung (z. B. 3 V) positiver ist als der Wert des Versorgungsspannungspotentials VEE (- 5 V). Damit stellen sich zugleich die Ausgangssignalpegel der Nicht-Oder-Stufe NOR auf 0 V für einen digitalen H-Pegel und auf -2 V für einen digitalen L-Pegel ein. Außerdem verschiebt sich die Schaltschwelle der Nicht-Oder-Stufe NOR auf einen Wert von ca. -1 V, da die Schaltschwelle bei CMOS-Schaltstufen in der Regel stets in der Mitte zwischen den Spannungswerten der Energieversorgung und damit für die Ausgangssignalpegel liegt.

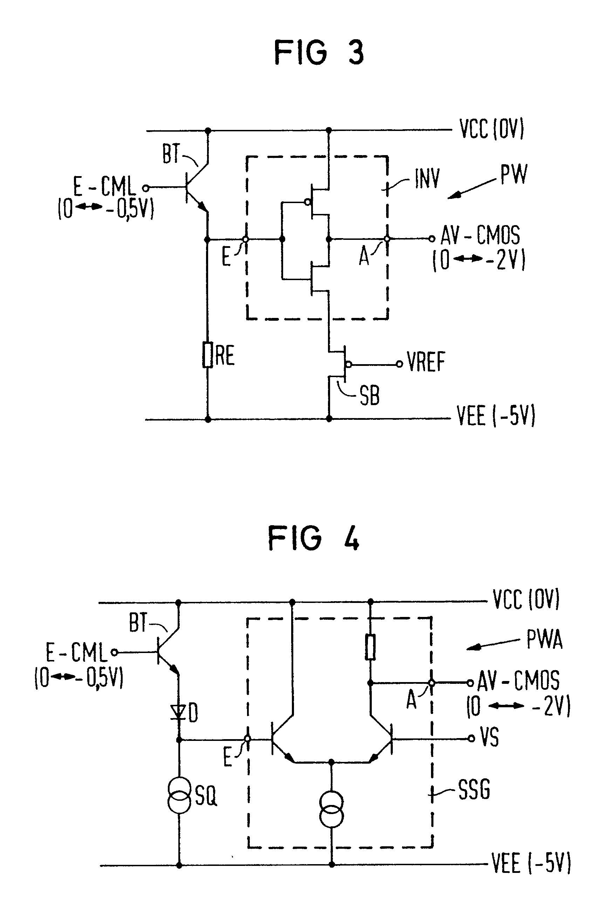

In der Figur 3 wird ein Stromlaufplan für einen in BICMOS-Technik realisierbaren Signalpegelwandler PW zur Umsetzung von CML-Ausgangssignalpegeln auf die Eingangssignalpegel von CMOS-Schaltstufen mit verringertem Signalpegelhub dargestellt.

Dieser Signalpegelwandler PW besteht im wesentlichen aus einer herkömmlichen CMOS-Inverterstufe INV (in der Figur durch eine unterbrochene Linie umrahmt) mit einem Invertereingang E und einem Inverterausgang A.

Die CMOS-Inverterstufe INV ist in identischer Weise zur Nicht- Oder-Stufe NOR nach Figur 1 mit dem Bezugspotential VCC und dem Versorgungsspannungspotential VEE verbunden. Zudem ist der Invertereingang E der CMOS-Inverterstufe INV an die Emitterelektrode eines als Emitterfolger betriebenen und als NPN-Transistor ausgebildeten Eingangstransistors BT angeschlossen und über einen Emitterwiderstand RE mit dem Versorgungsspannungspotential VEE verbunden. Die Kolektorelektrode des Eingangstransistors BT ist an das Bezugspotential VCC geführt und die Basiselektrode dient als Signalpegelwandlereingang E-CML für CML-Signalpegel.

Der Emitterfolger dient dazu, die Schaltschwelle der CMOS-Inverterstufe INV, die wie zur Figur 3 beschrieben, im Falle eines auf 2 V verringerten Siganlpegelhubes bei ca. -1 V liegt, an die etwa bei -0,25 V liegende Schaltschwelle der CML-Schaltstufen anzupassen. Bei einem Signalpegelhub von 2 V entspricht die Basis-Emitterspannung des Eingangstransistors BT vorteilhafterweise in etwa dem Differenzbetrag zwischen den beiden Schaltschwellen.

In der Figur 4 ist ein Stromlaufplan für einen in reiner Bipolartechnik realisierbaren Signalpegelwandler PWA dargestellt, der als Alternative zum dem Signalpegelwandler PW nach Figur 3 angesehen werden kann und wie dieser zur Umsetzung von CML-Signalpegeln auf die Signalpegel von CMOS-Schaltstufen mit verringertem Signalpegelhub dient.

Der Signalpegelwandler PWA nach Figur 4 besteht im wesentlichen aus einer CML-Schaltstufe SSG, die ausgangsseitig auf einen Signalpegelhub von ca. 2 V eingestellt ist und eingangsseitig mit Schaltungsmitteln zur Anpassung auf die bei etwa -0,25 V liegende Schaltschwelle von CML-Schaltstufen versehen ist.

Die CML-Schaltstufe SSG des Signalpegelwandlers PWA wird von einem aus einer Konstantstromquelle gespeisten Differenzverstärker gebildet, der einen ersten Verstärkerast mit einem Steuertransistor und einem zweiten Verstärkerast mit einem Referenztransistor aufweist. Beide Transistoren sind jeweils als NPN-Transistoren ausgebildet und an ihren Emitterelektroden miteinander verbunden und über die Konstantstromquelle an das Versorgungsspannunspotential VEE angeschlossen.

Als Eingang E der CML-Schaltstufe SSG wird die Basiselektrode des Steuertransistors verwendet. Als Ausgang A der CML-Schaltstufe SSG und gleichzeitig als Signalpegelwandlerausgang AV-CMOS dient die Kollektorelektrode des Referenztransistors, die über einen Arbeitswiderstand mit dem Bezugspotential VCC verbunden ist. Die Basiselektrode des Referenztransistors ist mit einem Konstantspannungspotential VS zur Einstellung der Schaltstufen-internen Schaltschwelle beaufschlagt. Die Konstantstromquelle und der Arbeitswiderstand sind so dimensioniert, daß sich im durchgeschalteten Zustand des Referenztransistors am Arbeitswiderstand ein Spannungsabfall von ca. 2 V einstellt.

Der Eingang E der CML-Schaltstufe SSG ist über eine weitere Konstantstromquelle SQ mit dem Versorgungsspannungspotential VEE und über eine in Flußrichtung gepolte Diode D mit der Emitterelektrode eines als Emitterfolger dienenden und als NPN-Transistor ausgebildeten Eingangstransistors BT verbunden. Der Eingangstransistor BT ist mit seiner Kollektorelektrode an das Bezugspotential VCC angeschlossen, und seine Basiselektrode dient als Signalpegelwandlereingang E-CML für CML-Signalpegel.

Der Wert der Basis-Emitterspannung des Eingangstransistors BT und der Wert der Diodenflußspannung addieren sich zu etwa 1,5 V und verschieben die bei 0 und -0,5 V liegenden CML-Signalpegel auf Spannungswerte von -1,5 V bzw. -2 V.

Die weitere Stromquelle SQ dient dazu, diese Spannungswerte dem Steuertransistor weitgehend unabhängig vom Basisstrom des Steuertransistors vorgeben zu können.

Der Wert des Konstantspannungspotentials VS an der Basis des Referenztransistors ist so bemessen, daß ein CML-H-Pegel am Signalpegelwandlereingang E-CML sicher in einen CMOS-H-Pegel am Signalpegelewandlerausgang AV-CMOS bzw. ein CML-L-Pegel am Signalpegelwandlereingang E-CML in einen CMOS-L-Pegel am Signalpegelwandlerausgang AV-CMOS umgesetzt wird, und außerdem bei einem CMOS-L-Pegel am Signalpegelwandlerausgang AV-CMOS der Referenztransistor nicht in Sättigung geht.

## Patentansprüche

1.  Schaltstufe mit einem ersten und einem zweiten Stromversorgungspfad zum Anschluß an jeweils ein Versorgungsspannungspotential, bei der ein Spannungsverringerungsglied (SB) in einem der Stromversorgungspfade realisiert ist,
    **dadurch gekennzeichnet,**
    daß zwischen den Strompfadanschlüssen des Spannungsverringerungsgliedes (SB) eine weitgehend stromstärkenunabhängige Spannungsdifferenz auftritt, wozu als Spannungsverringerungsglied (SB) ein MOS-Feldeffekttransistor oder ein Bipolartransistor vorgesehen ist, dessen Drain- und Sourceelektroden bzw. Kollektor- und Emitterelektroden als Strompfadanschlüsse dienen und dessen Gateelektrode bzw. Basiselektrode mit einem Referenzspannungspotential (VREF) zur Einstellung der Spannungsdifferenz beaufschlagt ist.

2.  Schaltstufe nach Anspruch 1, mit zur Bildung der Schaltstufe vorgesehenen MOS-Feldeffekttransistoren, deren maximal zulässige Drain-Source-Spannung betragsmäßig geringer ist als die Potentialdifferenz der Versorgungsspannungspotentiale (VEE, VCC).

3.  Schaltstufe nach Anspruch 1, als Schaltstufe mit verringertem Ausgangssignalpegelhub und entsprechend angepaßter Schaltschwelle in einer Digitalschaltung mit Stromschalterstufen (CML) zur Umsetzung von Stromschalterstufen-Ausgangssignalpegeln auf CMOS-Eingangssignalpegel mit angepaßter Schaltschwelle.

4.  Schaltstufe nach Anspruch 3,
    **dadurch gekennzeichnet,**
    daß die Spannungsdifferenz am Spannungsverringerungsglied (SB) derart bemessen ist, daß ein verringerter Ausgangssignalpegelhub mit einem Spannungswert von wenigstens annähernd 2 Volt auftritt.

5.  Schaltstufe nach Anspruch 4,
    **dadurch gekennzeichnet,**
    daß sie in einem Signalpegelwandler (PW) als eine CMOS-Inverterstufe ausgebildet ist, die über ein Spannungsverringerungsglied (SB) mit dem negativeren der beiden Versorgungsspannungspotentiale (VEE) verbunden ist und daß deren Inverterstufeneingang (E) an die Emitterelektrode eines als Emitterfolger beschalteten Eingangstransistors (BT) angeschlossen ist, dessen Basiselektrode als Signalpegelwandlereingang (E-CML) dient.

6.  Schaltstufe nach Anspruch 1,
    **dadurch gekennzeichnet,**
    daß sie in einem Signalpegelwandler (PWA) als eine Stromschalterstufe (CML) ausgebildet ist, die an ihrem Schaltstufeneingang (E) über eine Konstantstromquelle (SQ) mit dem negativeren der beiden Versorgungsspannungspotentiale (VEE) und über eine in Flußrichtung gepolte Diode (D) mit der Emitterelektrode eines als Emitterfolger beschalteten Eingangstransistors (BT) verbunden ist, dessen Basiselektrode als Signalpegelwandlereingang (E-CML) dient.

## FIG 1

## FIG 2

# FIG 3

# FIG 4

Europäisches
Patentamt

**EUROPÄISCHER
RECHERCHENBERICHT**

Nummer der Anmeldung

**EP 90 12 4635**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 7, Nr. 115 (E-176)[1260], 19. Mai 1983; & JP-A-58 34 956 (NIPPON DENKI) 01-03-1983 * Figuren a,b; Zusammenfassung * | 1 | H 03 K 19/0185 H 03 K 19/018 |
| X | EP-A-0 082 567 (MOTOROLA) * Figuren 1-3; Seite 3, Zeilen 13-21; Seite 10, Zeile 29 - Seite 11, Zeile 7 * | 1 | |
| Y | US-A-4 453 095 (WRATHALL) * Figur 2A; Spalte 4, Zeilen 6-58 * | 1,3-4,6 | |
| Y | PATENT ABSTRACTS OF JAPAN, Band 11, Nr. 190 (E-517)[2637], 18. Juni 1987; & JP-A-62 20 420 (HITACHI) 29-01-1987 * Ganzes Dokument * | 1,3-4,6 | |
| A | RADIO FERNSEHEN ELEKTRONIK, Band 37, Nr. 5, 1988, pages 292-295, Berlin, DE; M. AUER: "Stromschalttechnik in LSI- und VLSI-Schaltungen" * Bild 17; Seite 294, mittlere Spalte, Absatz 4 * | 6 | RECHERCHIERTE SACHGEBIETE (Int. Cl.5) |
| D,A | DE-A-3 300 869 (DEUTSCHE ITT INDUSTRIES) * Patentanspruch * | 1 | H 03 K |

Der vorliegende Recherchenbericht wurde für alle Patentansprüche erstellt

| Recherchenort | Abschlußdatum der Recherche | Prüfer |
|---|---|---|
| Den Haag | 23 Juli 91 | JEPSEN J. |